# EUROPÄISCHE PATENTSCHRIFT

(11) **EP 1 454 949 B1**
(45) Veröffentlichungstag und Bekanntmachung des Hinweises auf die Patenterteilung: **06.07.2016**
(21) Anmeldenummer: 04004108.9
(22) Anmeldetag: 24.02.2004
(51) Int. Cl.: C08K 5/5313, C08K 5/3492, C08K 5/17, C08K 5/51, H05K 1/03

(54) **Flammschutzmittel-Dispersion**
Flame retardant dispersion
Dispersion d'agent ignifugeant

(30) Priorität: 05.03.2003 DE 10309805
(43) Veröffentlichungstag der Anmeldung: 08.09.2004
(73) Patentinhaber: Clariant Produkte (Deutschland) GmbH, 65929 Frankfurt am Main (DE)
(72) Erfinder: Sicken, Martin, Dr., 51149 Köln (DE); Knop, Susanne, Dr., 22455 Hamburg (DE); Hörold, Sebastian, Dr., 86420 Diedorf (DE); Bauer, Harald, Dr., 50170 Kerpen (DE)

(56) Entgegenhaltungen:
- EP-A- 1 024 167
- EP-A- 1 024 168
- EP-A- 1 070 754

## Beschreibung

Die vorliegende Erfindung betrifft eine Flammschutzmittel-Dispersion, ein Verfahren zur Herstellung dieser Flammschutzmittel-Dispersion sowie deren Verwendung.

Phosphororganische Verbindungen finden Anwendung als Flammschutzmittel für thermoplastische und duroplastische Kunststoffe, wie z.B. Polyamide, Polyester, ungesättigte Polyesterharze und Epoxidharze.

Insbesondere die Salze von Phosphinsäuren (Phosphinate) haben sich als wirksame flammhemmende Zusätze erwiesen; die gilt sowohl für die Alkalimetallsalze
(DE-A-2 252 258) als auch für die Salze anderer Metalle (DE-A-2 447 727).

Calcium- und Aliminiuniphosphinate sind in Polyestern als besonders wirksam beschrieben worden und beeinträchtigen die Materialeigenschaften der Polymerformmassen weniger als die Alkalimetallsalze (EP-A-0 699 708).

Darüber hinaus wurden synergistische Kombinationen von Phosphinaten mit bestimmten stickstoffhaltigen Verbindungen gefunden, die in einer ganzen Reihe von Polymeren als Flammschutzmittel effektiver wirken, als die Phosphinate allein (US-A-6,255371, DE-A-196 14 424, DE-A-199 03 707).

Die EP-A-1 024 167 beschreibt eine Flammschutzmitelkombination für thermoplastische Polymere, welche als Komponente (A) 5 bis 30 Masseteile eines Salzes einer Diphosphonsäure, als Komponente (B) 10 bis 100 Masseteile einer stickstoffhaltigen Verbindung oder 5 bis 30 Masseteile einer P/N-Verbindung enthält. Die in der EP-A-1 024 167 genannten flüssigen Harze sind das Material, in das die vorgenannte Flammschutzmittelkombination eingearbeitet wird.

Die EP-A-1 024 168 betrifft flammwidrige duroplastische Massen, die mindestens ein (Di)Phosphinsäuresalz und mindestens eine synergistisch wirkende Komponente aus der Substanzreihe Metallhydroxid, Stickstoffverbindung oder Phosphor-Stickstoff-Verbindung enthält. Flüssige Komponenten sind hier nicht zugegen.

Wegen ihrer Brennbarkeit benötigen thermoplastische und duroplastische Kunststoffe, wie z. B. Polyamide, Polyester, ungesättigte Polyesterharze, Epoxidharze und Polyurethane für einige Anwendungen Flammschutzmittel. Zunehmende Anforderungen des Marktes an den Brandschutz und an die Umweltfreundlichkeit von Produkten erhöhen das Interesse an halogenfreien Flammschutzmitteln wie z.B. festen phosphororganischen Flammschutzmitteln oder Kombination solcher Produkte mit weiteren Flammschutzmitteln, vorzugsweise stickstoffhaltigen Synergisten oder Phosphor/Stickstoff Flammschutzmitteln.

In den vorgenannten Anwendungsgebieten kann die Verarbeitung der festen phosphororganischen Flammschutzkomponente vor allem dann erschwert sein, wenn im Verarbeitungsprozess flüssige Komponenten zum Einsatz kommen. Es besteht die Gefahr, dass es während der Verarbeitung aufgrund mangelnder Dispergierung oder Benetzung nicht gelingt, das Flammschutzmittel homogen einzuarbeiten.

Es bestand somit die Aufgabe, die Verarbeitbarkeit von Flammschutzmittelzusammensetzungen zu verbessern. Erfindungsgemäß wird die Aufgabe gelöst, indem die phosphororganische Flammschutzkomponente vor dem Kunststoff-Verarbeitungsprozeß mit einer flüssigen Komponente versetzt und homogenisiert wird. Überraschend wurde dabei gefunden, dass die Gleichmäßigkeit der Verteilung der phosphororganischen Flammschutzkomponente im Polymer verbessert wird, wenn man sie als Dispersion einsetzt. Die besser verteilten Partikel ergeben eine effektivere Flammschutzwirkung. Weitere Resultate der besseren Partikelverteilung sind eine bessere und ästhetischere Oberflächenbeschaffenheit und -güte. Außerdem können so auch bessere mechanische Eigenschaften des polymeren Werkstoffes erzielt werden.

US-A-4,097,400 beschreibt Mischungen des festen Flammschutzmittels Ammoniumpolyphosphat in Polyolen zur Herstellung von Polyurethanen.

Die Erfindung betrifft daher Flammschutzmittel-Dispersionen, welche dadurch gekennzeichnet sind, dass sie als Flammschutzkomponente A 1 bis 90 Gew.% Phosphinsäuresalz der Formel (I) und/oder ein Diphosphinsäuresalz der Formel (II) und/oder deren Polymere, 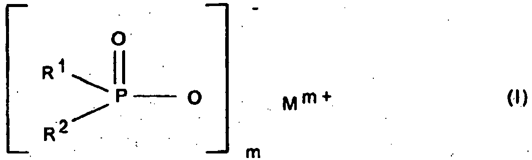 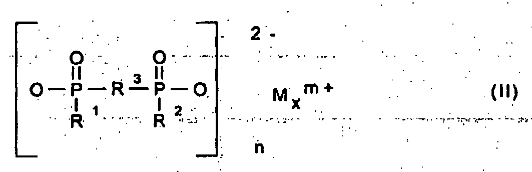 worin
- R¹, R²: gleich oder verschieden sind und Methyl, Ethyl, n-Propyl, iso-Propyl, n-Butyl, tert.-Butyl, n-Pentyl und/oder Phenyl
- R³: C₁-C₁₀-Alkylen, linear oder verzweigt, C₆-C₁₀-Arylen,-Alkylarylen oder -Arylalkylen;
- M: Mg, Ca, Al, Sb, Sn, Ge, Ti, Zn, Fe, Zr, Ce, Bi, Sr, Mn, Li, Na und/oder K ;
- m: 1 bis 4;
- n: 1 bis 4;
- x: 1 bis 4
bedeuten, als Komponente B 0 bis 75 Gew.% eines stickstoffhaltigen Synergisten oder eines Phosphor/Stickstoff Flammschutzmittels sowie als Komponente C 10 bis 90 Gew.% einer flüssigen Komponente enthält wobei es sich dabei um Aceton, Methylethylketon, Alkohole, Wasser, Benzol, Toluol, Xylole, Ester, Dimethylformamid, Aikylglykole Propylenglykolmethyletheracetat Diethylenglycolethyletheracetat, Polyethylenglycoldimethylether, Ethylacetat, Butylacetat, Dioxan, Tetrahydrofuran, Dimethylether, Dimethylether, Methyl-tert.-butylether, Alkane, Cycloalkane, N-Methyl-Pyrrolidon, Essigsäure, Essigsäureanhydrid, Ameisensäure, Propionsäure, Benzine, Amylacetat, Pyridin, Schwefelkohlenstoff, Dimethylsulfoxid, Dichlormethan, Trichlormethan, Tetrachlorkohlenstoff, Nitromethan, N-Dimethylacetamid und/oder Nitrobenzol handelt.

Bevorzugt bedeutet R³ Methylen, Ethylen, n-Propylen, iso-Propylen, n-Butylen, tert.-Butylen, n-Pentylen, n-Octylen oder n-Dodecylen; Phenylen oder Naphthylen; Methyl-phenylen, Ethyl-phenylen, tert.-Butylphenylen, Methyl-naphthylen, Ethyl-naphthylen oder tert.-Butylnaphthylen; Phenyl-methylen, Phenyl-ethylen, Phenyl-propylen oder Phenyl-butylen.

Bevorzugt bedeutet M Calcium, Aluminium oder Zink.

Unter protonierten Stickstoffbasen werden bevorzugt die protonierten Basen von Ammoniak, Melamin, Triethanolamin, insbesondere NH₄⁺, verstanden.

Bevorzugt handelt es sich bei der Komponente B um Kondensationsprodukte des Melamins, um Melem, Melam, Melon und/oder höherkondensierte Verbindungen davon.

Bevorzugt handelt es sich bei der Komponente B auch um Umsetzungsprodukte von Melamin mit Polyphosphorsäure und/oder um Umsetzungsprodukte von Kondensationsprodukten des Melamins mit Polyphosphorsäure oder Gemische davon.

Bevorzugt handelt es sich bei den Umsetzungsprodukten um Dimelaminpyrophosphat, Melaminpolyphosphat, Melempolyphosphat, Melampolyphosphat, Melonpolyphosphat und/oder gemischte Polysalze dieses Typs.

Bevorzugt enthält die Flammschutzmittel-Dispersion 10 bis 90 Gew.-% Komponente A, 0 bis 75 Gew.-% Komponente B und 10 bis 90 Gew.-% Komponente C.

Besonders bevorzugt enthält die Flammschutzmittel-Dispersion 10 bis 65 Gew.-% Komponente A, 10 bis 65 Gew.-% Komponente B und 25 bis 75 Gew.-% Komponente C.

Das bevorzugte Verfahren zur Herstellung dieser Flammschutzmittel-Dispersionen ist die Einmischung der festen Komponenten A und B in die flüssige Komponente C mittels eines Dissolver-Rühraggregates.

Die Erfindung betrifft auch eine flammwidrig ausgerüstete thermoplastische Kunststoff-Formmasse, hergestellt durch Einsatz der erfindungsgemäßen Flammschutzmittel-Dispersion.

Bevorzugt handelt es sich bei dem thermoplastischen Kunststoff um Polymere der Art Polystyrol-HI (High-Impact), Polyphenylenether, Polyamide, Polyester, Polycarbonate und Blends oder Polymerblends vom Typ ABS (Acrylnitril-Butadien-Styrol) oder PC/ABS (Polycarbonat/ Acrylnitril-Butadien-Styrol) oder PPE/HIPS (Polyphenylenether/Polystyrol-HI) Kunststoffe.

Die Erfindung betrifft auch flammwidrige duroplastische Massen, dadurch gekennzeichnet, dass es sich hierbei um Formmassen, Beschichtungen oder Laminate aus duroplastischen Harzen handelt, dadurch gekennzeichnet, dass sie duroplastische Harze und die Flammschutzmittel-Dispersion gemäß einem oder mehreren der Ansprüche 1 bis 8 enthalten.

Die flammwidrige duroplastische Massen sind dadurch gekennzeichnet, dass es sich hierbei um ungesättigte Polyesterharze, Epoxidharze oder Polyurethane handelt.

Schließlich betrifft die Erfindung auch Polymer-Formkörper, -Filme, -Fäden und -Fasern enthaltend eine Formmasse gemäß einem oder mehreren der Ansprüche 10 bis 11.

Erfindungsgemäß sind auch Flammschutzmittel-Zusammensetzungen, die synergistische Kombinationen von den genannten Phosphinaten mit bestimmten Verbindungen, die in einer ganzen Reihe von Polymeren als Flammschutzmittel effektiver wirken als die Phosphinate allein (US-A-6,255,371, DE-A-196 14 424, DE-A-1-99 03 707), enthalten. Die Flammschutzwirkung der Phosphinat-Mischungen kann durch Kombination mit weiteren Flammschutzmitteln, vorzugsweise stickstoffhaltigen Synergisten oder Phosphor/Stickstoff Flammschutzmitteln verbessert werden.

Bevorzugt handelt es sich bei den stickstoffhaltigen Synergisten um solche der Formeln (III) bis (VIII) oder Gemische davon, 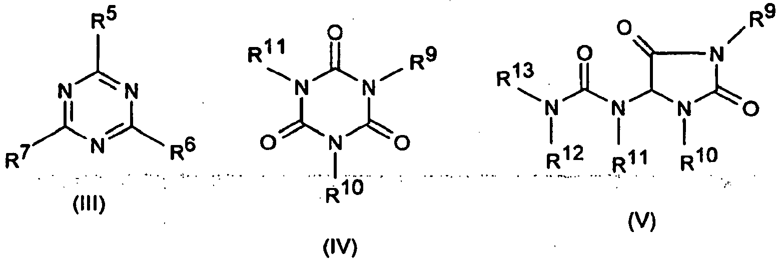 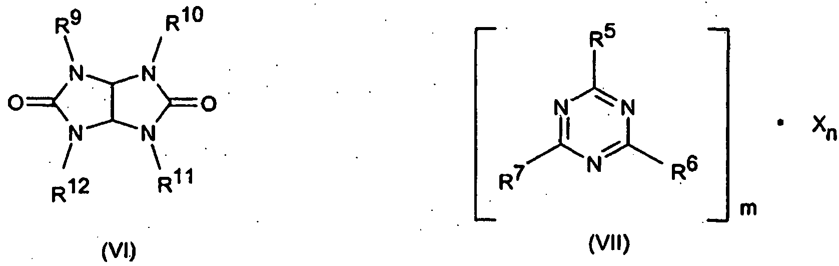 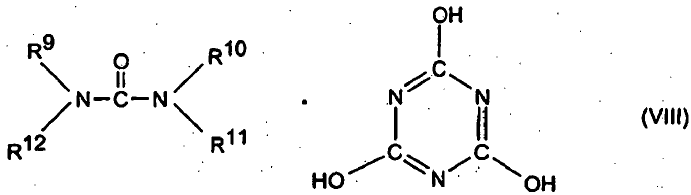 worin
- R⁵ bis R⁷: Wasserstoff, C₁-C₈-Alkyl, C₅-C₁₆-Cycloalkyl oder -Alkylcycloalkyl, möglicherweise substituiert mit einer Hydroxy- oder einer C₁-C₄-Hydroxyalkyl-Funktion, C₂-C₈-Alkenyl, C₁-C₈-Alkoxy, -Acyl, -Acyloxy, C₆-C₁₂-Aryl oder -Arylalkyl, -OR⁸ und -N(R⁸)R⁹, sowie N-alicyclisch oder N-aromatisch,
- R⁸: Wasserstoff, C₁-C₈-Alkyl, C₅-C₁₆-Cycloalkyl oder -Alkylcycloalkyl, möglicherweise substituiert mit einer Hydroxy- oder einer C₁-C₄-Hydroxyalkyl-Funktion, C₂-C₈-Alkenyl, C₁-C₈-Alkoxy, -Acyl, -Acyloxy oder C₆-C₁₂-Aryl oder -Arylalkyl,
- R⁹ bis R¹³: die gleichen Gruppen wie R⁸ sowie -O-R⁸,
- m und n: unabhängig voneinander 1, 2, 3 oder 4,
- X: Säuren, die Addukte mit Triazinverbindungen (III) bilden können, bedeuten;
oder um oligomere Ester des Tris(hydroxyethyl)isocyanurats mit aromatischen Polycarbonsäuren handelt.

Bevorzugt handelt es sich bei den stickstoffhaltigen Synergisten um Benzoguanamin, Tris(hydroxyethyl)isocyanurat, Allahtoin, Glycouril, Melamin, Melamincyanurat, Dicyandiamid, Guanidin, Carbodiimide, Zinkborat.

Bevorzugt handelt es sich bei den Phosphor/Stickstoff Flammschutzmitteln um stickstoffhaltige Phosphate der Formeln (NH₄)_{y} H_{3-y} PO₄ bzw. (NH₄ PO₃)_{z}, mit y gleich 1 bis 3 und z gleich 1 bis 10.000.

Bevorzugt handelt es sich bei den Phosphor/Stickstoff Flammschutzmitteln um Ammoniumhydrogenphosphat, Ammoniumdihydrogenphosphat oder Ammoniumpolyphosphat.

Als flüssige Komponenten kommen alle Produkte in Frage, die in den jeweiligen Herstell- oder Verarbeitungsverfahren der Kunststoffe eingesetzt werden, bzw. die zusätzlich eingesetzt werden, ohne die oben genannten Prozesse zu stören. Beispiele für solche flüssigen Zusätze sind Monomere, die in Polymerisations-, Polyadditions- oder Polykondensationsreaktionen eingesetzt werden, Lösungsmittel die bei der Kunststoff-Verarbeitung zum Einsatz kommen, flüssige polymere Grundprodukte sowie Stabilisatoren, weitere Flammschutzmittel und sonstige Hilfsmittel.

Geeignete Monomere sind Diole, wie sie bei der Herstellung von Polyestern eingesetzt werden. Beispiele sind Ethylenglykol, 1,2-Propandiol, 1,3-Propandiol und Butandiole.

Geeignete flüssige polymere Grundprodukte sind Polyole und Polyisocyanate, die zur Herstellung von Polyurethanen zum Einsatz kommen.

Beispiele für Polyole sind Polyethylenglycole, Polypropylenglykole, Polyetherpolyole und Polyesterpolyole.

Beispiele für geeignete Lösungsmittel sind Aceton, Methylethylketon, Alkohole, Wasser, Benzol, Toluol, Xylole, Ester, Dimethylformamid, Alkylglykole, Propylenglykolmethyletheracetat, Diethylenglycolethyletheracetat, Polyethylenglycoldimethylether, Ethylacetat, Butylacetat, Dioxan, Tetrahydrofuran, Diethylether, Dimethylether, Methyl-tert.-butylether, Alkane, Cycloalkane, N-Methyl-Pyrrolidon, Essigsäure. Essigsäureanhydrid, Ameisensäure. Propionsäure, Benzine, Amylacetat, Pyridin, Schwefelkohlenstoff, Dimethylsulfoxid, Dichlormethan, Trichlormethan, Tetrachlorkohlenstoff, Nitromethan, N-Dimethylacetamid, Nitrobenzol.

Besonders geeignet sind die Alkohole Methanol, Ethanol, n-Propanol, i-Propanol, n-Butanol, i-Butanol, sek-Butanol, tert.-Butanol, n-Hexanol, 2-Ethylhexanol.

Die erfndungsgemäßen Flammschutzmitteldispersionen enthalten bevorzugt die flüssige Komponente (C) und die festen Komponenten (A + B) im Gewichtsverhältnis 1 zu 9 bis 9 zu 1, besonders bevorzugt 1 zu 3 bis 3 zu 1.

Die Flammschutzmitteldispersionen können niedrigviskos und feststoffarm sein aber auch hohe Viskositäten aufweisen und dabei hohe Mengen an Feststoff enthalten.

Besonders bevorzugt sind Mengenverhältnisse, die zu Mischungsviskositäten von 2000 bis 10000 mPa·s führen. Derartige Dispersionen lassen sich in der Regel gut verarbeiten.

Gegebenenfalls können bei der Herstellung der Dispersionen Dispergieradditive eingesetzt werden, um eine noch weiter verbesserte Vordispergierung der Flammschutzmittel zu erreichen.

Zur Verhinderung von Sedimentation können den Dispersionen auch Stabilisatoren zugesetzt werden. Beispiele für solche Stabilisatoren sind Schichtsilicate und Tonminerale z.B. Bentonite, Montmorillonite, Hectorite, Saponite und gefällte/pyrogene/kristalline/amorphe Kieselsäuren.

In einer anderen Ausführungsform enthält die Flammschutzmittel 25 bis 75 Gew.-% Komponente A und 25 bis 75 Gew.-% Komponente C.

Besonders bevorzugt handelt es sich bei dem thermoplastischen Kunststoff um Polyamide, Polyester und PPE/HIPS-Blends.

Bevorzugt enthalten die thermoplastischen Kunststoffe Füllstoffe, wie beispielsweise Glas (bevorzugt in Kugel oder in Faserform), Oxide und/oder Hydroxide der Elemente der zweiten und dritten Hauptgruppe des Periodensystems der Elemente (bevorzugt Aluminium und Magnesium), Schichtsilicate und Tonminerale z.B.

Die Erfindung betrifft auch flammwidrige duroplastische Massen, dadurch gekennzeichnet, dass es sich hierbei um Formmassen, Beschichtungen oder Laminate aus duroplastischen Harzen handelt, die mittels der erfindungsgemäßen Flammschutzmittel-Dispersion hergestellt wurden.

Bevorzugt handelt es sich bei den duroplastischen Harzen um ungesättigte Polyesterharze, Epoxidharze und Polyurethane.

Ungesättigte Polyesterharze sind Lösungen von Polykondensationsprodukten aus gesättigten und ungesättigten Dicarbonsäuren oder deren Anhydriden mit Diolen in copolymerisierbaren Monomeren, vorzugsweise Styrol oder Methylmethacrylat. UP-Harze werden gehärtet durch radikalische Polymerisation mit Initiatoren (z.B. Peroxiden) und Beschleunigern. Die Doppelbindungen der Polyesterkette reagieren mit der Doppelbindung des copolymerisierbaren Lösungsmittelmonomers. Die wichtigsten Dicarbonsäuren zur Herstellung der Polyester sind Maleinsäureanhydrid, Fumarsäure und Terephthalsäure. Das am häufigsten verwendete Diol ist 1,2-Propandiol. Darüber hinaus werden auch Ethylenglycol, Diethylenglykol und Neopentylglycol u.a. verwendet. Das geeignetste Monomer zur Vernetzung ist Styrol. Styrol ist beliebig mit den Harzen mischbar und lässt sich gut copolymerisieren. Der Styrolgehalt in ungesättigten Polyesterharzen liegt normalerweise zwischen 25 und 40 %. Anstelle von Styrol kann auch Methylmethacrylat als Monomeres verwendet werden.

Epoxidharze sind Verbindungen, die durch Polyadditionsreaktion von einer Epoxidharz-Komponente und einer Vernetzungs-(Härter) Komponente hergestellt werden. Als Epoxidharz Komponente werden aromatische Polyglycidylester wie Bisphenol-A-diglycidylester, Bisphenol-F-diglycidylester, Polyglycidylester von Phenol-Formaldehydharzen und Kresol-Formaldehydharzen, Polyglycidylester von Pththal-, Isophthal- und Terephthalsäure sowie von Trimellithsäure, N-Glycidylverbindungen von aromatischen Aminen und heterocyclischen Stickstoffbasen sowie Di- und Polyglycidylverbindungen von mehrwertigen aliphatischen Alkoholen verwendet.
Als Härter finden Polyamine wie Triethylentetramin, Aminoethylpiperazin und Isophorondiamin, Polyamidoamine, mehrbasige Säure oder deren Anhydride wie z.B. Phthalsäureanhydrid, Hexahydrophthalsäureanhydrid, Methyltetrahydrophthalsäureanhydrid oder Phenole Verwendung. Die Vernetzung kann auch durch Polymerisa-tion unter Verwendung geeigneter Katalysatoren erfolgen.

Epoxidharze sind geeignet zum Verguss von elektrischen bzw. elektronischen Bauteilen und für Tränk- und Imprägnierprozesse. In der Elektrotechnik werden die verwendeten Epoxidharze überwiegend flammwidrig ausgerüstet und für Leiterplatten und Isolatoren eingesetzt.

Epoxidharze für Leiterplatten werden nach dem bisherigen Stand der Technik durch Einreagieren bromhaltiger aromatischen Verbindungen, insbesondere. Tetrabrombisphenol A, flammwidrig eingestellt. Nachteilig ist, dass im Brandfall Bromwasserstoff (Gefahrstoff!) freigesetzt wird, was zu Schäden durch Korrosion führen kann. Unter ungünstigen Bedingungen können auch polybromierte Dibenzodioxine und Furane entstehen. Die Verwendung von Aluminiumhydroxid scheidet wegen der bei der Verarbeitung erfolgenden Wasserabspaltung vollständig aus.

Der Brandschutz elektrischer und elektronischer Ausrüstungen ist in Vorschriften und Normen zur Produktsicherheit festgelegt. In den USA werden brandschutztechnische Prüf- und Zulassungsverfahren von Underwriters Laboratories (UL) durchgeführt. Die UL Vorschriften werden heute weltweit akzeptiert. Die Brandprüfungen für Kunststoffe wurden entwickelt, um den Widerstand der Materialien gegenüber Entzündung und Flammenausbreitung zu ermitteln.

Je nach Brandschutzanforderungen müssen die Materialien horizontale Brenntests (Klasse UL 94 HB oder die strengeren vertikalen Tests (UL 94 V2, V1 oder V-0) bestehen. Diese Prüfungen simulieren Zündquellen geringer Energie, die in Elektrogeräten auftreten und auf Kunststoffteile elektrischer Baugruppen einwirken können.

Die erfindungsgemäßen Flammschutzmittel-Dispersionen werden bevorzugt in Compounds angewendet, die weiter zur Erzeugung von Polymer-Formkörpern verwendet werden.

Erfindungsgemäß sind auch Polymer-Formkörper, die auf Basis der efindungsgemäßen Flammschutzmitteldispersion hergestellt worden sind.

Die Einarbeitung der Flammschutzmittel-Dispersionen in duroplastische Kunststoffe erfolgt durch homogene Vermischung mit den entsprechenden Harz/Härter-Systemen und anschließende Härtung und Formgebung.
Die Flammschutzmitteldispersionen können in thermoplastische Polymere eingearbeitet werden, indem z.B. alle Bestandteile in einem Mischer vorgemischt und anschließend in einem Compoundieraggregat (z.B. einem Doppelschneckenextruder) in der Polymerschmelze homogenisiert werden. Die Schmelze wird üblicherweise als Strang abgezogen, gekühlt und granuliert. Die Komponenten können auch separat über eine Dosieranlage direkt in das Compoundieraggregat eingebracht werden.

Es ist ebenso möglich, die Flammschutzmitteldispersionen einem fertigen Polmergranulat bzw. -pulver beizumischen und die Mischung direkt auf einer Spritzgussmaschine zu Formteilen zu verarbeiten.

Als universell einsetzbare Möglichkeit, die Flammwidrigkeit von Werkstoffen zu bestimmen hat sich die Bestimmung des sogenannten Saüerstoffindexes bewährt. In dieser Testanordnung wird anhand eines vertikal angeordneten Prüfkörpers die Grenz-Sauerstoffkonzentration eines vertikal verlaufenden Abbrandes ermittelt. Der Sauerstoffindex (LOI) wurde in einer modifizierten Apparatur in Anlehnung an ASTM_D 2863-74 bestimmt.

### Beispiele:

### Eingesetzte Komponenten:

^{®}Alpolit SUP 403 BMT (Vianova Resins GmbH, Wiesbaden), ungesättigtes Polyesterharz, ca. 57%ig in Styrol, Säurezahl max. 30 mgKOH/g, vorbeschleunigt und schwach thixotrop eingestellt, niedrigviskos (Viskosität im Auslaufbecher 4 mm: 110 ± 10 s) und stark reduzierte Styrolemissionen.
^{®}Palatal 340 S (DSM-BASF Structural Resins, Ludwigshafen) ungesättigtes Polyesterharz, ca. 49 %ig in Styrol und Methyimethacrylat, Dichte 1,08 g/ml, Säurezahl 7 mgKOH/g, vorbeschleunigt, niedrigviskos (dynamische Viskosität ca. 50 mPa*s).
^{®}Beckopox EP 140 (Vianova Resins GmbH, Wiebaden), niedrigmolekulares Kondensationsprodukt aus Bisphenol A und Epichlorhydrin mit einer Dichte von 1,16 g/ml und einem Epoxidäquivalent von 180 - 192.
^{®}Beckopox EH 625 (Vianova Resins GmbH, Wiesbaden), modifiziertes aliphatisches Polyamin mit einem H-Aktiväquivalentgewicht von 73 und einer dynamischen Viskosität von ca. 1000 mPa*s.

Kobaltbeschleuniger NL 49P (Akzo Chemie GmbH, Düren) Kobaltoktoatlösung in Dibutylphtalat mit einem Kobaltgehalt von 1 Masse %
^{®}Butanox M 50 (Akzo Chemie GmbH, Düren) Methylethylketonperoxid, mit Dimethylphtalat phlegmatisiert, klare Flüssigkeit mit einem Aktiv-Sauerstoffgehalt von mind. 9 Masse %.
^{®}Dowanol PMA (Fa. Dow), Propylenglykolmethyletheracetat
^{®}Durethan AKV 30 (Fa. Bayer AG, D), Polyamid 6.6 (PA 6.6-GV), enthält 30 % Glasfasern.
^{®}Celanex 2300 GV1/30 (Fa. Ticona, D) Polybutylenterephthalat (PBT-GV), enthält 30 % Glasfasern,

Aluminiumsalz der Diethylphosphinsäure, im folgenden als DEPAL bezeichnet.
^{®}Melapur 200 (Melaminpolyphosphat), im folgenden als MPP bezeichnet, Fa. DSM Melapur, NL

### Beispiele 1 bis 5

Mit Hilfe einer Dissolver-Rührapparatur wurden Flammschutzmittel-Dispersionen hergestellt, indem die flüssige Komponente vorgelegt wurde und unter kräftigem Rühren über 10 min der Feststoff eingetragen wurde. Anschließend wurde bei Raumtemperatur weitere 30 min homogenisiert.

**Tabelle 1: Flammsehutzmittel-Dispersionen**

| Bsp. | Feststoff (Komponente A bzw. A +B) | Gew.-% | Flüssigkeit (Komponente C) | Gew.-% | Viskosität [mPa.s] |
|---|---|---|---|---|---|
| 1 | DEPAL | 50 | Methylethylketon | 50 | 2750 |
| 2 | DEPAL | 50 | Toluol | 50 | 3050 |
| 3 | DEPAL | 50 | Dowanol PMA | 50 | 2460 |
| 4 | DEPAL | 50 | Resorcindiphosphorsäuretetraphenylester | 50 | 6700 |
| 5 | DEPAL/MPP (1:1) | 50 | Resorcindiphosphorsäuretetraphenylester | 50 | 6450 |

### Polyesterharzherstellung

Das ungesättigte Polyesterharz wird zunächst mit dem Kobaltbeschleuniger, anschließend mit dem Flammschutzmittel-Feststoff (Komponente A) mit einer Dissolverscheibe vermischt. Nach Zugabe des Peroxidhärters Butanox M 50 wird nochmals homogenisiert. In einer beheizten Presse werden auf einer ^{®}Hostaphan Trennfolie und einem Stahlrahmen zwei Lagen Textilglas-Endlosmatte vom Flächengewicht 450 g/m² eingelegt. Anschließend wird etwa die Hälfte des Harz-Flammschutzmittel-Gemisches gleichmäßig verteilt. Nach Zugabe einer weiteren Glasmatte wird das restliche Harz-Flammschutzmittel-Gemisch verteil, das Laminat mit einer Trennfolie abgedeckt und bei einer Temperatur von 50°C während einer Stunde bei einem Pressdruck von 10 bar eine Pressplatte von 4 mm Dicke hergestellt.

Tabelle 2 zeigt Vergleichsbeispiele zur Verwendung von DEPAL als Flammschutzmittel für ungesättigte Polyesterharze (Viapal UP 403 BMT und^{®} Alpolit SUP 403 BMT). Aus der Tabelle ist zu entnehmen, dass beim Einsatz von 25 Teilen festem DEPAL pro 100 Teile ungesättigtes Polyesterharz (Vergleichsbeispiele 10 - 11) relativ niedrige Werte für den Sauerstoff-Index (LOI) erhalten werden und eine rauhe, fleckige Oberfläche zu beobachten ist.

**Tabelle 2: Eigenschaften von ungesättigtem Polyester Harz Laminaten, mit 30 Gew.% Textilglas-Endlosmatte, Härter Butanox M50, Beschleuniger NL 49 P, Endkonzentration jeweils 25 Teile Flammschutzmittel/100 Teile Harz**

| Beispiel | Flammschutz-Dispersion | Harz | Oberfläche | LOI |
|---|---|---|---|---|
| 6 (Vgl.) | DEPAL* | ^{®}Palatal 340 S | Rau/Fleckig | 0,30 |
| 7(Vgl.) | DEPAL* | ^{®}Alpolit SUP 403 BMT | Rau/Fleckig | 0,32 |

| | | | | |
|---|---|---|---|---|
| * als Feststoff | | | | |

### Beispiel 8 (Vergleich)

Das Epoxidharz Beckopox EP 140 wird mit dem Flammschutzmittel-Feststoff mit einer Dissolverscheibe vermischt Nach Zugabe des Härters Beckopox EH 625 wird nochmals homogenisiert. Das Harz-Flammschutzmittel-Gemisch wird auf eine Stahlplatte aufgebracht und ein Glasseidengewebe mit einem Flächengewicht von 86 g/m² aufgelegt. Anschließend wird weiteres Harz-Flammschutzmittel-Gemisch aufgetragen und eine Lage Glasseidengewebe mit einem Flächengewicht von 390 g/m² aufgelegt. Dieser Vorgang wird weitere viermal wiederholt. Anschließend wird 3 h bei 120°C gehärtet. Es entsteht ein Laminat von etwa 3 mm Dicke.

### Beispiele 9 bis 11

Das Epoxidharz Beckopox EP 140 wird mit den Flammschutzmittel-Dispersionen gemäß den Beispielen 1 bis 3 mit einer Dissolverscheibe vermischt. Nach Zugabe des Härters Beckopox EH 625 wird nochmals homogenisierte Das Harz-Flammschutzmittel-Gemisch wird wie in Beispielen 8 beschrieben, zu einem Laminat von etwa 3 mm Dicke verarbeitet.

Die Tabelle 3 zeigt Ergebnisse von Epoxidharzlaminaten auf Basis des Harzes Beckopox EP 140 und dem Polyaminhärter Härter Beckopox EH 625. Mit dem Einsatz des Flammschutzmittels DEPAL in Form einer Dispersion (Beispiele 9 bis 11) sind sowohl höhere Sauerstoffindex-Werte (LOI) zu erreichen, als auch eine unbeeinträchtigte Oberflächenbeschaffenheit. Die erfindungsgemäßen Laminate bestehen auch eine forcierte Lagerung (1 h/120°C/1.00 %rel. Feuchte) ohne unerwünschte Delaminierung, die beim Einsatz des Feststoffes zu beobachten ist.

**Tabelle 3: Eigenschaften von Epoxidharz-Formkörpern, Materialstärke 3,0 mm; Harz 100 Teile Beckopox EP 140, Härter 39 Teile Beckopox EH 625, Endkonzentration jeweils 20 Teile Flammschutzmittel/100 Teile Harz**

| Beispiel | Flammschutz-Dispersion | 1 h Lagerung bei 120°C/100% rel. Feuchte | Oberfläche | LOI |
|---|---|---|---|---|
| 8 (Vgl.) | DEPAL* | Delaminierung | Rau/Fleckig | 0,30 |
| 9 | Nach Beispiel 1 | Keine Delaminierung | Glatt/homogen | 0,38 |
| 10 | Nach Beispiel 2 | Keine Delaminierung | Glatt/homogen | 0,39 |
| 11 | Nach Beispiel 3 | Keine Delaminierung | Glatt/homogen | 0,40 |

| | | | | |
|---|---|---|---|---|
| *als Feststoff | | | | |

### Beispiele 12 und 13 (Vergleich)

Das glasfaserverstärkte Polyamid- bzw. PBT-Granulat wurde auf einem Doppelschnecken-Extruder (Typ Leistritz LSM 30/34) bei Temperaturen von 260 bis 310°C (PA 6.6-GV) bzw. von 240 bis 280°C (PBT-GV) extrudiert. Das Flammschutzmittel-Pulver wurde über einen Seiteneinzug in die aufgeschmolzene Polymermasse eindosiert. Der homogenisierte Polymerstrang wurde abgezogen, im Wasserbad gekühlt und anschließend granuliert. Nach ausreichender Trocknung wurden die Formmassen auf einer Spritzgießmaschine (Typ Arburg 320 C Allrounder) bei Massetemperaturen von 270 bis 320°C (PA 6.6-GV) bzw. von 260 bis 280°C (PBT-GV) zu Prüfkörpern verarbeitet.

### Beispiele 14 bis 17

Das glasfaserverstärkte Polyamid- bzw. PBT-Granulat wurde auf einem Doppelschnecken-Extruder (Typ Leistritz LSM 30/34) bei Temperaturen von 260 bis 310°C (PA 6.6-GV) bzw. von 240 bis 280°C (PBT-GV) extrudiert. Die Flammschutzmittel-Dispersionen wurden über einen Seiteneinzug in die aufgeschmolzene Polymermasse eindosiert. Der homogenisierte Polymerstrang wurde abgezogen, im Wasserbad gekühlt und anschließend granuliert. Nach ausreichender Trocknung wurden die Formmassen auf einer Spritzgießmaschine (Typ Arburg 320 C Allrounder) bei Massetemperaturen von 270 bis 320°C (PA 6.6-GV) bzw. von 260 bis 280°C (PBT-GV) zu Prüfkörpern verarbeitet.

Der Tabelle 4 ist zu entnehmen, dass beim Einsatz von 20 % festem DEPAL (Vergleichsbeispiele 12 und 13) relativ niedrige Werte für den Sauerstoff-Index (LOI) erhalten werden und eine rauhe, fleckige Oberfläche zu beobachten ist. Mit dem Einsatz von DEPAL in Form von Dispersionen (Beispiele 14 bis 17) sind sowohl höhere Sauerstoffindex-Werte (LOI) zu erreichen, als auch eine unbeeinträchtigte Oberflächenbeschaffenheit.

**Tabelle 4: Eigenschaften von Flammschutz-Formkörpern auf Basis von Polyamid (PA 6.6.) bzw. Polybutylenterephthalat (PBT); jeweils 20 % Flammschutzmittelgehalt**

| Beispiel | Flammschutz-Dispersion | Polymer | Oberfläche | LOI |
|---|---|---|---|---|
| 12 (Vgl.) | DEPAL* | ^{®}Celanex 2300 GV1/30 | Rau/Fleckig | 0,30 |
| 13 (Vgl.) | DEPAL* | ^{®}Durethan AKV 30 | Rau/Fleckig | 0,31 |
| 14 | Nach Beispiel 4 | ^{®}Celanex 2300 GV1/30 | Glatt/homogen | 0,39 |
| 15 | Nach Beispiel 5 | ^{®}Celanex 2300 GV1/30 | Glatt/homogen | 0,39 |
| 16 | Nach Beispiel 4 | ^{®}Durethan AKV 30 | Glatt/homogen | 0,41 |
| 17 | Nach Beispiel 5 | ^{®}Durethan AKV 30 | Glatt/homogen | 0,40 |

## Patentansprüche

1. Flammschutzmittel-Dispersionen, **dadurch gekennzeichnet, dass** sie als Flammschutzkomponente A 1 bis 90 Gew.-% Phosphinsäuresalz der Formel (I) und/oder ein Diphosphinsäuresalz der Formel (II) und/oder deren Polymere enthält, 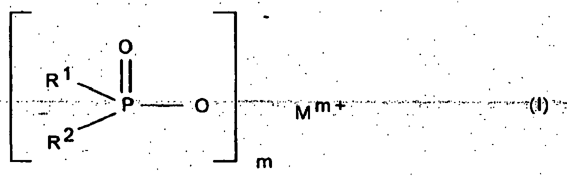 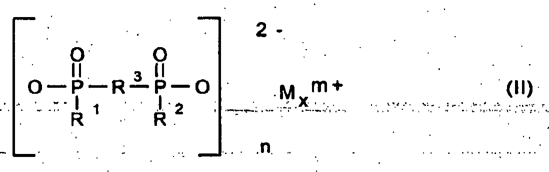 worin
R¹, R² gleich oder verschieden sind und Methyl, Ethyl, n-Propyl, isopropyl, n-Butyl, tert.-Butyl, n-Pentyl und/oder Phenyl
R³ C₁-C₁₀-Alkylen, linear oder verzweigt, C₆-C₁₀-Arylen, -Alkylarylen oder -Arylalkylen;
M Mg, Ca, Al, Sb, Sn, Ge, Ti, Zn, Fe, Zr, Ce, Bi, Sr, Mn, Li, Na und/oder K ;
m 1 bis 4;
n 1 bis 4;
x 1 bis 4
bedeuten, als Komponente B 0 bis 75 Gew.-% eines stickstoffhaltigen Synergisten oder eines Phosphor/Stickstoff Flammschutzmittels sowie als Komponente C 10 bis 90 Gew.% einer flüssigen Komponente enthält wobei es sich dabei um Aceton, Methylethylketon, Alkohole, Wasser, Benzol, Toluol, Xylole, Ester, Dimethylformamid, Alkylglykole Propylenglykolmethyletheracetat Diethylenglycolethyletheracetat, Polyethylenglycoldimethylether, Ethylacetat, Butylacetat, Dioxan, Tetrahydrofuran, Diethylether, Dimethylether, Methyl-tert.-butylether, Alkane, Cycloalkane. N-Methyl-Pyrrolidon, Essigsäure, Essigsäureanhydrid, Ameisensäure, Propionsäure, Benzine, Amylacetat, Pyridin, Schwefelkohlenstoff, Dimethylsulfoxid, Dichlormethan, Trichlormethan, Tetrachlorkohlenstoff, Nitromethan, N-Dimethylacetämid und/oder Nitrobenzol handelt.

2. Flammschutzmittel-Dispersion nach Anspruch 1, **dadurch gekennzeichnet, dass** R³ Methylen. Ethylen, n-Propylen, iso-Propylen, n-Butylen, tert.-Butylen, n-Pentylen, n-Octylen oder n-Dodecylen, Phenylen oder Naphthylen; Methyl-phenylen, Ethyl-phenylen, tert.-Butylphenylen, Methyl-naphthylen, Ethyl-naphthylen oder tert.-Butylnaphthylen; Phenyl-methylen, Phenyl-ethylen, Phenyl-propylen oder Phenylbutylen bedeutet.

3. Flammschutzmittel-Dispersion nach Anspruch 1 oder 2, **dadurch gekennzeichnet, dass** es sich bei der Komponente B um Kondensationsprodukte des Melamins, um Melem, Melam, Melon und/oder höherkondensierte Verbindungen davon handelt.

4. Flammschutzmittel-Dispersion nach einem oder mehreren der Ansprüche 1 bis 3, **dadurch gekennzeichnet, dass** es sich bei der Komponente B um Umsetzungsprodukte von Melamin mit Polyphosphorsäure und/oder um Umsetzungsprodukte von Kondensationsprodukten des Melamins mit Polyphosphorsäure oder Gemische davon handelt.

5. Flammschutzmittel-Dispersion Anspruch 4, **dadurch gekennzeichnet, dass** es sich bei den Umsetzungsprodukten um Dimelaminpyrophosphat, Melaminpolyphosphat, Melempolyphosphat, Melampolyphosphat, Melonpolyphosphat und/oder gemischte Polysalze dieses Typs handelt.

6. Flammschutzmittel-Dispersion nach einem oder mehreren der Ansprüche 1 bis 5, **dadurch gekennzeichnet, dass** 10 bis 90 Gew.-% Komponente A, 0 bis 75 Gew.-% Komponente B und 10 bis 90 Gew.% Komponente C enthalten sind.

7. Flammschutzmittel-Dispersion nach einem oder mehreren der Anspruche 1 bis 6, **dadurch gekennzeichnet, dass** 10 bis 65 Gew.-% Komponente A, 10 bis 65 Gew.-% Komponente B und 25 bis 75 Gew.% Komponente C enthalten sind.

8. Flammschutzmittel-Dispersion nach einem oder mehreren der Ansprüche 1 bis 6, **dadurch gekennzeichnet, dass** 25 bis 75 Gew.-% Komponente A und 25 bis 75 Gew.-% Komponente C enthalten sind.

9. Verfahren zur Herstellung von Flammschutzmittel-Dispersionen gemäß einem oder mehreren der Ansprüche 1 bis 8, **dadurch gekennzeichnet, dass** die Einmischung der festen Komponenten A und B in die flüssige Komponente C mittels eines Dissolver-Rühraggregates erfolgt.

10. Flammwidrig ausgerüstete thermoplastische Kunststoff-Formmasse, hergestellt durch Einsatz der Flammsehützmittel Dispersionen gernäß einem oder mehreren der Ansprüche 1 bis 8.

11. Flammwidrig ausgerüstete thermoplastische Kunststoff-Formmasse nach Anspruch 10, **dadurch gekennzeichnet, dass** es sich bei dem thermoplastischen Kunststoff um Polystyrol-HI (High-Impact), Polyphenylenether, Polyamid, Polyester, Polycarbonate und Blends oder Polymerblends vom Typ ABS (Acrylnitril-Butadien-Styrol) oder PC/ABS (Polycarbonat/ Acrylnitril-Butadien-Styrol) oder PPE/HIPS (Polyphenylenether/Polystyrol-HI) Kunststoffe handelt.

12. Flammwidrige duroplastische Massen, **dadurch gekennzeichnet, dass** es sich hierbei um Formmassen, Beschichtungen oder Laminate aus duroplastischen Harzen handelt, **dadurch gekennzeichnet, dass** sie duroplastische, Harze und die Flammschutzmittel-Dispersion gemäß einem oder mehreren der Ansprüche 1 bis 8 enthalten.

13. Flammwidrige duroplastische Massen gemäß Anspruch 12, **dadurch gekennzeichnet, dass** es sich hierbei um ungesättigte Polyesterharze, Epoxidharze oder Polyurethane handelt.

14. Polymer-Formkörper, -Filme, -Fäden und -Fasern enthaltend eine Formmasse gemäß einem oder mehreren der Ansprüche 10 bis 11.

## Claims

1. A flame retardant dispersion which comprises, as flame retardant component A, from 1 to 90% by weight of phosphinic salt of the formula (I), and/or a diphosphinic salt of the formula (II), and/or polymers of these, 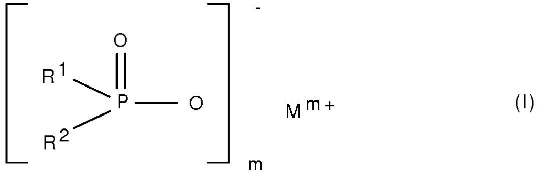 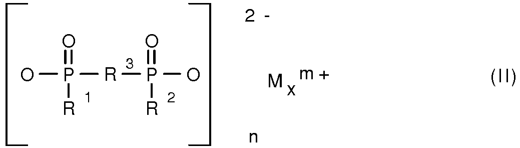 where
R¹and R² are identical or different and are methyl, ethyl, n-propyl, isopropyl, n-butyl, tert-butyl, n-pentyl, and/or phenyl,
R³ is C₁-C₁₀-alkylene, linear or branched, C₆-C₁₀-arylene, -alkylarylene, or -arylalkylene;
M is Mg, Ca, Al, Sb, Sn, Ge, Ti, Zn, Fe, Zr, Ce, Bi, Sr, Mn, Li, Na and/or K;
m is from 1 to 4;
n is from 1 to 4;
x is from 1 to 4,
and comprises, as component B, from 0 to 75% by weight of a nitrogen-containing synergist or of a phosphorus/nitrogen flame retardant, and comprises, as component C, from 10 to 90% by weight of a liquid component which comprises acetone, methyl ethyl ketone, alcohols, water, benzene, toluene, xylenes, esters, dimethylformamide, alkyl glycols, propylene glycol methyl ether acetate, diethylene glycol ethyl ether acetate, polyethylene glycol dimethyl ether, ethyl acetate, butyl acetate, dioxane, tetrahydrofuran, diethyl ether, dimethyl ether, methyl tert-butyl ether, alkanes, cycloalkanes, N-methylpyrrolidone, acetic acid, acetic anhydride, formic acid, propionic acid, petroleum spirit, amyl acetate, pyridine, carbon disulfide, dimethyl sulfoxide, dichloromethane, trichloromethane, carbon tetrachloride, nitromethane, N-dimethylacetamide, and/or nitrobenzene.

2. The flame retardant dispersion as claimed in claim 1, wherein R³ is methylene, ethylene, n-propylene, isopropylene, n-butylene, tert-butylene, n-pentylene, n-octylene or n-dodecylene; phenylene or naphthylene; methylphenylene, ethylphenylene, tert-butylphenylene, methylnaphthylene, ethylnaphthylene or tert-butylnaphthylene; phenylmethylene, phenylethylene, phenylpropylene, or phenylbutylene.

3. The flame retardant dispersion as claimed in claim 1 or 2, wherein component B comprises condensation products of melamine, or comprises melem, melam, melon and/or compounds thereof having higher condensation levels.

4. The flame retardant dispersion as claimed in one or more of claims 1 to 3, wherein component B comprises reaction products of melamine with polyphosphoric acid and/or comprises reaction products of condensation products of melamine with polyphosphoric acid, or comprises a mixture thereof.

5. The flame retardant dispersion as claimed in claim 4, wherein the reaction products comprise dimelamine pyrophosphate, melamine polyphosphate, melem polyphosphate, melam polyphosphate, melon polyphosphate, and/or mixed polysalts of this type.

6. The flame retardant dispersion as claimed in one or more of claims 1 to 5, which comprises from 10 to 90% by weight of component A, from 0 to 75% by weight of component B, and from 10 to 90% by weight of component C.

7. The flame retardant dispersion as claimed in one or more of claims 1 to 6, which comprises from 10 to 65% by weight of component A, from 10 to 65% by weight of component B, and from 25 to 75% by weight of component C.

8. The flame retardant dispersion as claimed in one or more of claims 1 to 6, which comprises from 25 to 75% by weight of component A and from 25 to 75% by weight of component C.

9. A process for preparing flame retardant dispersions as claimed in one or more of claims 1 to 8, which comprises incorporating the solid components A and B into the liquid component C by mixing by means of a dissolver mixer assembly.

10. A flame-retardant thermoplastic molding composition, prepared by using the flame retardant dispersions as claimed in one or more of claims 1 to 8.

11. The flame-retardant thermoplastic molding composition as claimed in claim 10, wherein the thermoplastic is HI (high-impact) polystyrene, polyphenylene ethers, polyamides, polyesters, polycarbonates, and blends or polyblends of the type represented by ABS (acrylonitrile-butadiene-styrene) or PC/ABS (polycarbonate/ acrylonitrile-butadiene-styrene) or PPE/HIPS (polyphenylene ether/HI polystyrene) plastics.

12. A flame-retardant thermoset composition which is a molding composition, a coating, or a laminate composed of thermoset resins, wherein said material comprises thermoset resins and the flame retardant dispersion as claimed in one or more of claims 1 to 8.

13. The flame-retardant thermoset composition as claimed in claim 12, which comprises unsaturated polyester resins, epoxy resins, or polyurethanes.

14. A polymer molding, a polymer film, a polymer filament, or a polymer fiber, comprising a molding composition as claimed in one or more of claims 10 to 11.

## Revendications

1. Dispersions d'agent ignifuge, **caractérisées en ce qu'**elles contiennent en tant que composant ignifuge A 1 à 90 % en poids d'un sel de l'acide phosphinique de formule (I) et/ou d'un sel de l'acide diphosphinique de formule (II) et/ou leurs polymères 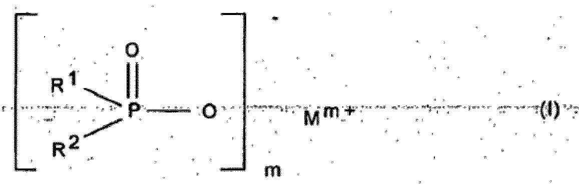 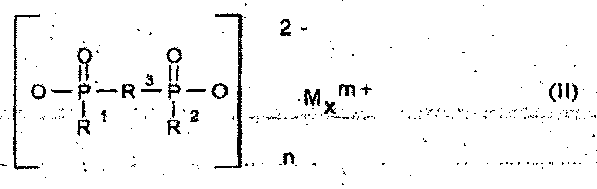 dans lesquelles
R¹, R² sont identiques ou différents, et signifient méthyle, éthyle, n-propyle, iso-propyle, n-butyle, tert.-butyle, n-pentyle et/ou phényle,
R³ signifie alkylène en C₁-C₁₀, linéaire ou ramifié, arylène, alkylarylène ou arylalkylène en C₆-C₁₀ ;
M signifie Mg, Ca, Al, Sb, Sn, Ge, Ti, Zn, Fe, Zr, Ce, Bi, Sr, Mn, Li, Na et/ou K ;
m signifie 1 à 4 ;
n signifie 1 à 4 ;
x signifie 1 à 4,
en tant que composant B 0 à 75 % en poids d'un synergiste azoté ou d'un agent ignifuge phosphore/azote, et en tant que composant C 10 à 90 % en poids d'un composant liquide, qui consiste en l'acétone, la méthyléthylcétone, des alcools, l'eau, le benzène, le toluène, des xylènes, des esters, le diméthylformamide, des alkylglycols, l'acétate d'éther méthylique de propylène glycol, l'acétate d'éther éthylique de diéthylène glycol, l'éther diméthylique de polyéthylène glycol, l'acétate d'éthyle, l'acétate de butyle, le dioxane, le tétrahydrofurane, l'éther diéthylique, l'éther diméthylique, l'éther de méthyle et de tert.-butyle, des alcanes, des cycloalcanes, la N-méthyl-pyrrolidone, l'acide acétique, l'anhydride de l'acide acétique, l'acide formique, l'acide propionique, des essences, l'acétate d'amyle, la pyridine, le sulfure de carbone, le diméthylsulfoxyde, le dichlorométhane, le trichlorométhane, le tétrachlorocarbone, le nitrométhane, le N-diméthylacétamide et/ou le nitrobenzène.

2. Dispersion d'agent ignifuge selon la revendication 1, **caractérisée en ce que** R³ signifie méthylène, éthylène, n-propylène, iso-propylène, n-butylène, tert.-butylène, n-pentylène, n-octylène ou n-dodécylène ; phénylène ou naphtylène ; méthyl-phénylène, éthyl-phénylène, tert.-butylphénylène, méthyl-naphtylène, éthyl-naphtylène ou tert.-butylnaphtylène ; phényl-méthylène, phényl-éthylène, phényl-propylène ou phényl-butylène.

3. Dispersion d'agent ignifuge selon la revendication 1 ou 2, **caractérisée en ce que** le composant B consiste en des produits de condensation de mélamine, le mélem, le mélam, le melon et/ou leurs composés condensés supérieurs.

4. Dispersion d'agent ignifuge selon une ou plusieurs des revendications 1 à 3, **caractérisée en ce que** le composant B consiste en des produits de réaction de mélamine avec de l'acide polyphosphorique et/ou des produits de réaction de produits de condensation de mélamine avec de l'acide polyphosphorique ou leurs mélanges.

5. Dispersion d'agent ignifuge selon la revendication 4, **caractérisée en ce que** les produits de réaction sont le pyrophosphate de dimélamine, le polyphosphate de mélamine, le polyphosphate de mélem, le polyphosphate de mélam, le polyphosphate de melon et/ou des polysels mixtes de ce type.

6. Dispersion d'agent ignifuge selon une ou plusieurs des revendications 1 à 5, **caractérisée en ce que** 10 à 90 % en poids du composant A, 0 à 75 % en poids du composant B et 10 à 90 % en poids du composant C sont contenus.

7. Dispersion d'agent ignifuge selon une ou plusieurs des revendications 1 à 6, **caractérisée en ce que** 10 à 65 % en poids du composant A, 10 à 65 % en poids du composant B et 25 à 75 % en poids du composant C sont contenus.

8. Dispersion d'agent ignifuge selon une ou plusieurs des revendications 1 à 6, **caractérisée en ce que** 25 à 75 % en poids du composant A et 25 à 75 % en poids du composant C sont contenus.

9. Procédé de fabrication de dispersions d'agent ignifuge selon une ou plusieurs des revendications 1 à 8, **caractérisé en ce que** l'incorporation des composants solides A et B dans le composant liquide C a lieu au moyen d'un appareil d'agitation dissolveur.

10. Matériau de moulage plastique thermoplastique ignifugé, fabriqué en utilisant les dispersions d'agent ignifuge selon une ou plusieurs des revendications 1 à 8.

11. Matériau de moulage plastique thermoplastique ignifugé selon la revendication 10, **caractérisé en ce que** le plastique thermoplastique est le polystyrène HI (High Impact), l'éther de polyphénylène, les polyamides, les polyesters, les polycarbonates et les alliages ou alliages polymères de type ABS (acrylonitrile-butadiène-styrène) ou PC/ABS (polycarbonate/acrylonitrile-butadiène-styrène) ou PPE/HIPS (éther de polyphénylène/polystyrène HI).

12. Matériaux duroplastiques ignifugés, **caractérisés en ce qu'**il s'agit de matériaux de moulage, de revêtements ou de stratifiés en résines duroplastiques, **caractérisés en ce qu'**ils contiennent des résines duroplastiques et la dispersion d'agent ignifuge selon une ou plusieurs des revendications 1 à 8.

13. Matériaux duroplastiques ignifugés selon la revendication 12, **caractérisés en ce qu'**il s'agit de résines de polyester insaturées, de résines d'époxyde ou de polyuréthanes.

14. Corps moulés, films, fils et fibres polymères contenant un matériau de moulage selon une ou plusieurs des revendications 10 à 11.
